# EUROPÄISCHE PATENTANMELDUNG

(11) **EP 4 726 772 A1**
(43) Veröffentlichungstag der Anmeldung: **15.04.2026**
(21) Anmeldenummer: 24206434.3
(22) Anmeldetag: 14.10.2024
(51) Int. Cl.: H01L 21/67, B29D 11/00, G02C 7/02, H01L 21/677, G02B 1/10, H01L 21/687

(54) **BEHANDLUNGSANLAGE FÜR OPTISCHE SUBSTRATE, VERWENDUNG EINES KOPPELMECHANISMUS BEI EINER SOLCHEN BEHANDLUNGSANLAGE SOWIE VERFAHREN ZUM BETRIEB EINER BEHANDLUNGSANLAGE**

(71) Anmelder: Bühler Alzenau GmbH, 63755 Alzenau (DE)
(72) Erfinder: Henkel, Stefan, 63755 Alzenau (DE); Messenzehl, Jürgen, 63755 Alzenau (DE); Kuhr, Niels, 63755 Alzenau (DE)
(74) Vertreter: Prinz & Partner mbB

(57) **Zusammenfassung**

Eine Behandlungsanlage (10) für optische Substrate (12) hat wenigstens eine evakuierte Substrataufnahmekammer (32, 34) und wenigstens eine evakuierte Substratbehandlungskammer (28). Eine Substrattransporteinrichtung (22) hat wenigstens einen starren Schwenkarm (24), der an einem ersten Ende (25) an einer Schwenkwelle (36) fixiert ist und an einem zweiten Ende (42) eine Koppelvorrichtung (44) aufweist, über die der Schwenkarm (24) mit einem Substrathalter (14) koppelbar ist, wobei die Schwenkwelle (36) in der Substrataufnahmekammer (30, 32, 34) angeordnet ist. Der Schwenkarm (24) ist zumindest zwischen einer ersten Arbeitsposition (38) und einer zweiten Arbeitsposition (40) verschwenkbar, wobei die erste Arbeitsposition (38) in der Substrataufnahmekammer (30, 32, 34) und die zweite Arbeitsposition (40) in der Substratbehandlungskammer (28) liegt. Die Substrattransporteinrichtung (22) ist so ausgebildet, dass die Koppelvorrichtung (44) sowohl an der ersten Arbeitsposition (38) als auch an der zweiten Arbeitsposition (40) mit dem Substrathalter (14) koppelbar und vom Substrathalter (14) entkoppelbar ist. Ferner ist die Verwendung eines Koppelmechanismus bei einer Behandlungsanlage (10) und ein Verfahren zum Betrieb einer Behandlungsanlage (10) beschrieben.

## Beschreibung

Die Erfindung betrifft eine Behandlungsanlage für optische Substrate. Ferner betrifft die Erfindung die Verwendung eines Koppelmechanismus bei einer Behandlungsanlage für optische Substrate sowie ein Verfahren zum Betrieb einer Behandlungsanlage.

Es ist aus dem Stand der Technik bekannt, dass optische Substrate, beispielsweise Brillenglassubstrate, in Behandlungsanlagen wenigstens einem Behandlungsschritt unterzogen werden, der typischerweise im Vakuum stattfindet. Für Behandlungsschritte von Substraten, die im Vakuum stattfinden, ist der Transport der Substrate in und durch die Vakuumkammern einer Behandlungsanlage ein Zeit- und Kostenfaktor.

Zudem muss beim Transport der Substrate in den Vakuumkammern sichergestellt sein, dass die Substrate nicht durch Partikel verunreinigt werden, die z.B. durch Abriebprozesse einer Transportvorrichtung im Inneren der Vakuumkammern erzeugt werden. Außerdem sollte es möglich sein, ein ausreichendes Vakuum in den Vakuumkammern aufrechtzuerhalten.

Darüber hinaus muss das jeweilige optische Substrat der Behandlungsanlage zugeführt und anschließend aus der Behandlungsanlage entnommen werden, wobei auch hier insbesondere zu beachten ist, dass das Vakuum aufrechterhalten wird.

Insofern sind, z.B. zum Beladen, Positionieren, Reinigen und Beschichten der Substrate, zahlreiche Schritte bei der Behandlung von optischen Substraten zu berücksichtigen.

Aufgabe der Erfindung ist es, in einer Behandlungsanlage den Transport optischer Substrate zu vereinfachen, insbesondere innerhalb der Vakuumkammern der Behandlungsanlage.

Diese Aufgabe wird durch eine Behandlungsanlage für optische Substrate gelöst, die wenigstens eine Substrataufnahmekammer und wenigstens eine Substratbehandlungskammer aufweist. Die Substrataufnahmekammer und die Substratbehandlungskammer sind als evakuierbare Vakuumkammern ausgebildet. Außerdem weist die Behandlungsanlage eine Substrattransporteinrichtung auf, die dazu ausgelegt ist, einen Substrathalter mit einer Vielzahl von Halterungen für zu behandelnde optische Substrate von der Substrataufnahmekammer in die Substratbehandlungskammer zu bewegen. Die Substrattransporteinrichtung weist wenigstens einen starren Schwenkarm auf, der an einem ersten Ende an einer Schwenkwelle fixiert ist und an einem zweiten Ende eine Koppelvorrichtung aufweist, über die der Schwenkarm mit dem Substrathalter koppelbar ist. Die Schwenkwelle ist in der Substrataufnahmekammer angeordnet. Der Schwenkarm ist in einer Schwenkebene zumindest zwischen einer ersten Arbeitsposition und einer zweiten Arbeitsposition verschwenkbar, die beide auf einem Bewegungskreisbogen liegen, entlang dem sich die Koppelvorrichtung bewegen kann, wobei die erste Arbeitsposition in der Substrataufnahmekammer und die zweite Arbeitsposition in der Substratbehandlungskammer liegt. Die Substrattransporteinrichtung ist so ausgebildet, dass die Koppelvorrichtung sowohl an der ersten Arbeitsposition als auch an der zweiten Arbeitsposition mit dem Substrathalter koppelbar und vom Substrathalter entkoppelbar ist.

Länge und Form des Schwenkarms und damit auch dessen Schwenkebene sowie der Bewegungskreisbogen sind fest vorgegeben und ändern sich bei der Bewegung des Schwenkarms nicht.

Die Verwendung eines starren Schwenkarms zum Transport des Substrathalters hat unter anderem den Vorteil, dass an jeder Position des Bewegungskreisbogens die gleichen Kräfte auf die Koppelvorrichtung wirken und somit eine gleichmäßige Bewegung des Schwenkarms und des Substrathalters über den gesamten Bewegungskreisbogen ohne nennenswerte Positionsabweichungen sichergestellt sind. Insofern erfolgt die Bewegung in definierter Weise, und die Positionierung des Substrathalters ist sehr genau reproduzierbar. Der Schwenkarm kann so auch für große und schwere Substrathalter von bis zu etwa einem Meter Durchmesser und mehreren hundert Kilogramm Gewicht ausgelegt werden. Andererseits ist eine derartige Behandlungsanlage auch für kleine Substrathalter mit einem Gewicht von wenigen Gramm und einem Durchmesser von nur einigen Millimetern bis Zentimetern nach dem gleichen Prinzip realisierbar. Die Behandlungsanlage muss in ihren Dimensionen natürlich spezifisch an den jeweiligen Anwendungszweck angepasst werden.

Außerdem kann der Schwenkarm rein durch eine Drehung der Schwenkwelle bewegt werden, was die Zahl der bewegten Teile im Inneren der Vakuumkammer gering hält, insbesondere auf ein Minimum reduziert. Somit reduziert sich auch insbesondere gegenüber Lösungen mit Rollensystemen oder Teleskoparmen die Menge der durch Abrieb erzeugten Partikel, die zu einer Verunreinigung der optischen Substrate beitragen könnten. Die Verwendung eines Schwenkarms ermöglicht daher gegebenenfalls auch, Vorbehandlungen, z.B. Reinigungsbehandlungen, der optischen Substrate zu reduzieren, was wiederum Zeit und Kosten spart. Der Schwenkarm ist außerdem nur einem geringen Verschleiß unterworfen. Somit lässt sich mit einer derartigen Behandlungsanlage insgesamt die Produktivität steigern.

Das einfache Bewegungsschema des Schwenkarms eignet sich zudem gut für einen hohen Automatisierungsgrad der Behandlungsanlage.

Außerdem baut die Behandlungsanlage sehr kompakt und ist daher auch bei geringem Platzangebot installierbar.

Generell ist mit einer derartigen Behandlungsvorrichtung die Behandlung optischer Substrate, vor allem für Konsumerprodukte, mit hoher Qualität bei kurzen Bearbeitungszeiten und hohem Durchsatz möglich.

Jede der Vakuumkammern ist grundsätzlich durch eine geeignete Strömungsverbindung mit einer Vakuumpumpe evakuierbar.

Die wenigstens eine Substrataufnahmekammer kann so angeordnet sein, dass sie von einem Reinraum her beladen und/oder entladen werden kann. Beispielsweise ist es denkbar, die Behandlungsanlage selbst in einem Grauraum aufzustellen, aber angrenzend an eine Wand zu einem Reinraum zu platzieren und wenigstens eine Substrataufnahmekammer durch eine Öffnung in dieser Wand zugänglich zu machen. Die Behandlungsanlage ist demnach zwischen dem Grauraum und dem Reinraum vorgesehen, da eine Seite der Behandlungsanlage dem Reinraum zugewandt ist, wohingegen eine andere Seite der Behandlungsanlage vom Grauraum her zugänglich ist. Ein Grauraum bezeichnet einen Bereich in der Umgebung der Behandlungsanlage, der weniger strengen Anforderungen an Partikelfreiheit unterliegt als der Reinraum.

Als "optische Substrate" werden in diesem Zusammenhang beispielsweise Brillenglassubstrate für Sehhilfen, Sportbrillen oder Sonnenbrillen bezeichnet, aber auch flächige Substrate für brillenähnliche Vorrichtungen etwa für Anwendungen im Bereich der virtuellen und erweiterten Realität (VR bzw. AR). Die optischen Substrate können gegebenenfalls auch andere flächige Substrate sein, z.B. Substrate für Heads Up-Displays oder optische Filter sein. Die Abmessungen der Substrate liegen optional zwischen einigen Millimetern und einigen Dezimetern.

Um die Steifigkeit und damit die Stabilität des Schwenkarms zu erhöhen, kann der Schwenkarm ein geeignetes Profil aufweisen, beispielsweise ein I- oder Doppel-T-Profil. Hierdurch ergibt sich eine hohe Biegesteifigkeit bei gleichzeitig geringerem Gewicht des Schwenkarms. Eine derartige Gestaltung bietet Vorteile für eine hohe Reproduzierbarkeit der Positionierung des Substrathalters beim Transport durch die Behandlungsanlage.

In einer Variante ist nur in der Substrataufnahmekammer eine Schwenkwelle angeordnet, während in der Substratbehandlungskammer keine Schwenkwelle vorhanden ist. Der Schwenkarm wird stets von der Substrataufnahmekammer in die Substratbehandlungskammer und dann wieder zurück verschwenkt. Beispielsweise wird der Substrathalter von der Substrataufnahmekammer in die Substratbehandlungskammer transportiert und dort vom Schwenkarm entkoppelt. Nach Entkoppeln des Substrathalters in der Substratbehandlungskammer wird dann der Schwenkarm in die Substrataufnahmekammer zurückbewegt, bevor eine Substratbehandlung in der Substratbehandlungskammer erfolgt. Dies hat unter anderem den Vorteil, dass in der Substrataufnahmekammer bereits ein weiterer Substrathalter gehandhabt, beispielsweise aus der Substrataufnahmekammer entladen oder in die Substrataufnahmekammer beladen, werden kann. Ein anderer Vorteil ist, dass der Schwenkarm nicht der in der Substratbehandlungskammer stattfindenden Substratbehandlung ausgesetzt ist und somit vom Behandlungsvorgang nicht erfasst, also z.B. nicht durch eine Beschichtung verschmutzt wird.

Wenn der Schwenkarm in einem Randbereich der Substrataufnahmekammer angeordnet ist, lässt sich einfach die erste Arbeitsposition in einem mittleren Bereich der Substrataufnahmekammer und die zweite Arbeitsposition in einem mittleren Bereich der Substratbehandlungskammer anordnen, sodass das Hantieren mit dem Substrathalter immer mitten in der jeweiligen Vakuumkammer erfolgen kann und das Volumen der Vakuumkammer möglichst klein gehalten werden kann und so die gesamte Abhandlungsanlage sehr kompakt ist.

Das Konzept der Verwendung von Schwenkarmen in Verbindung mit festgelegten Arbeitspositionen in unterschiedlichen Vakuumkammern, an denen der Substrathalter mit dem Schwenkarm gekoppelt und vom Schwenkarm entkoppelt werden kann, ermöglicht einen sehr variablen Transport des Substrathalters durch die Behandlungsanlage. Gleichzeitig erlaubt es auch eine flexible Anordnung der Vakuumkammern in der Behandlungsanlage. Ein Schwenkarm muss immer nur zwischen zwei benachbarten Vakuumkammern operieren. Da somit jeweils nur der Transport des Substrathalters zwischen zwei benachbarten Vakuumkammern zu betrachtet ist, ist eine Erweiterung der Behandlungsanlage um weitere Vakuumkammern mit und ohne Schwenkarme einfach möglich.

Im einfachsten Aufbau weist die Behandlungsanlage genau eine Substrataufnahmekammer und eine Substratbehandlungskammer auf.

Unter anderem in diesem Fall kann die Substrattransporteinrichtung dazu ausgelegt sein, den Substrathalter von der Substratbehandlungskammer in die Substrataufnahmekammer zurückzubewegen. Dies erfolgt normalerweise dann, wenn die Behandlung der optischen Substrate in der Substratbehandlungskammer abgeschlossen ist.

In einem komplexeren Aufbau kann die Behandlungsanlage mehrere Substrataufnahmekammern und optional auch mehrere Substratbehandlungskammern aufweisen.

Bei einer derartigen Behandlungsanlage ist die Substrattransporteinrichtung z.B. dazu ausgelegt, den Substrathalter von der Substratbehandlungskammer wahlweise in eine erste Substrataufnahmekammer und eine zweite Substrataufnahmekammer zu bewegen.

Hierbei kann zumindest eine der mehreren Substrataufnahmekammern ein Schleusenventil zu einem nicht evakuierten Bereich der Behandlungsanlage aufweisen und als Belade- und/oder Entladekammer für den Substrathalter dienen.

Das Schleusenventil bildet einen verschließbaren Durchgang in einer Wand einer Vakuumkammer zur Umgebung unter Normaldruck (also in einem nicht evakuierten Bereich) oder zu einer benachbarten Vakuumkammer. Das Schleusenventil ist z.B. ein Ventil mit einem Schieber oder einer Klappe. In einem geöffneten Zustand gibt das Schleusenventil eine Öffnung mit einer ausreichend großen Höhe und Breite frei, um den Substrathalter, ggf. zusammen mit dem daran gekoppelten Schwenkarm, hindurchzuführen. Im geöffneten Zustand kann daher durch das Schleusenventil ein Substrathalter in die Vakuumkammer eingebracht (beladen) oder aus der Vakuumkammer entnommen (entladen) werden bzw. von einer Vakuumkammer in eine benachbarte Vakuumkammer transferiert werden. Im geschlossenen Zustand verschließt das Schleusenventil die Öffnung z.B. ausreichend dicht, um eine der angrenzenden Vakuumkammern belüften zu können, ohne das Vakuum in den anderen Vakuumkammern zu beeinträchtigen. Der Druck in den einzelnen Vakuumkammern ist dann unabhängig eingestellbar. Beispielsweise kann in der Substratbehandlungskammer stets ein Vakuum aufrechterhalten werden, während die Substrataufnahmekammern zum Be- und Entladen des Substrathalters in der Regel belüftet und vor dem Transfer des Substrathalters in die Substratbehandlungskammer wieder evakuiert werden.

Wenn die Substrataufnahmekammer als Beladekammer dient, wird ein Substrathalter aus einem nicht evakuierten Bereich der Behandlungsanlage oder von außerhalb der Behandlungsanlage, insbesondere in einem Reinraum, in diese Substrataufnahmekammer eingebracht. In der Substrataufnahmekammer wird der Substrathalter mit dem dort angeordneten Schwenkarm gekoppelt. Daraufhin wird in einer möglichen Variante die Substrataufnahmekammer evakuiert. Der Substrathalter kann jetzt vom Schwenkarm in die benachbarte (evakuierte) Substratbehandlungskammer gebracht und dort vom Schwenkarm entkoppelt werden. Der Schwenkarm wird anschließend in die als Beladekammer dienende Substrataufnahmekammer zurückbewegt. Nach der Behandlung der optischen Substrate in der Substratbehandlungskammer übernimmt der Schwenkarm der als Entladekammer dienenden Substrataufnahmekammer, die zu diesem Zeitpunkt evakuiert ist, den Substrathalter und überführt den Substrathalter in diese Substrataufnahmekammer. Die Entladekammer kann jetzt belüftet werden, während die Substratbehandlungskammer evakuiert bleibt. Von der Entladekammer wird der Substrathalter wieder in einen nicht evakuierten Bereich überführt.

Es ist möglich, die erste oder die zweite Substrataufnahmekammer als dezidierte Beladekammer und dementsprechend die andere Substrataufnahmekammer als dezidierte Entladekammer zu verwenden. Es ist aber genauso denkbar, die erste und/oder die zweite Substrataufnahmekammer sowohl als Belade- als auch als Entladekammer einzusetzen.

Vor allem wenn die Behandlungsanlage mehr als drei Vakuumkammern aufweist, können die mehreren Substrataufnahmekammern zumindest eine Substrataufnahmekammer umfassen, die zu wenigstens zwei Vakuumkammern direkt benachbart angeordnet ist und in der zwei Schwenkwellen mit jeweils einem Schwenkarm angeordnet sind. Diese Substrataufnahmekammer dient dazu, den Substrathalter in einen anschließenden Bereich der Behandlungsanlage zu überführen, indem der Substrathalter von einem der Schwenkarme zum anderen übergeben wird.

Die Behandlungsanlage kann eine beliebige Kombination von Substratbehandlungskammern, Substrataufnahmekammern mit einer Schwenkwelle und einem Schwenkarm sowie Substrataufnahmekammern mit zwei Schwenkwellen und damit zwei Schwenkarmen umfassen, wodurch sich eine komplexe Substrattransporteinrichtung realisieren lässt, mit der ein Substrathalter durch die gesamte Behandlungsanlage bewegbar ist. Beispielsweise lässt sich so der Substrathalter nacheinander in unterschiedliche Substratbehandlungskammern bringen, in denen unterschiedliche chemische und/oder physikalische Behandlungen der optischen Substrate durchgeführt werden. Auch eine Rückbewegung in eine der Substratbehandlungskammern und/oder Substrataufnahmekammern wäre denkbar. Genauso lassen sich für den Substrathalter Verzweigungen oder Weichen in der Behandlungsanlage realisieren, beispielsweise um unterschiedliche Substrathalter zu unterschiedlichen Entladekammern zu bewegen oder um einen Substrathalter auf einem Warteplatz abzulegen, von dem er bei einem vorgegebenen Arbeitsschritt von einem geeigneten Schwenkarm wieder übernommen und weitertransportiert wird.

Generell gilt, dass alle Arbeitspositionen, die von zwei Schwenkarmen erreichbar sind, an Berühr- oder Schnittpunkten von Bewegungskreisbögen von Koppelvorrichtungen dieser beiden Schwenkarme liegen.

In einer möglichen Variante ist die Substratbehandlungskammer zwischen einer ersten Substrataufnahmekammer und einer weiteren Substrataufnahmekammer der mehreren Substrataufnahmekammern angeordnet, und in der ersten Substrataufnahmekammer und in der weiteren Substrataufnahmekammer ist jeweils zumindest eine Schwenkwelle mit einem Schwenkarm angeordnet, wobei die erste Substrataufnahmekammer und die weitere Substrataufnahmekammer jeweils über ein Schleusenventil mit einem nicht evakuierten Bereich, der zur Behandlungsanlage gehört oder sich außerhalb der Behandlungsanlage befindet, verbunden sind. Die erste Substrataufnahmekammer dient als Beladekammer und die weitere Substrataufnahmekammer als Entladekammer, oder die erste Substrataufnahmekammer dient als Entladekammer und die weitere Substrataufnahmekammer als Beladekammer.

In einer Variante sind die Substrataufnahmekammer und die Substratbehandlungskammer direkt benachbart zueinander angeordnet und durch ein Schleusenventil miteinander verbunden, sodass keine Belüftung der Substratbehandlungskammer erforderlich ist, wenn beispielsweise eine der Substrataufnahmekammern zum Beladen oder Entladen belüftet und geöffnet wird. Außerdem wird die Kontamination der Substrataufnahmekammern durch das Behandlungsverfahren in der Substratbehandlungskammer reduziert, da während der Behandlung das Schleusenventil geschlossen sein kann.

Um den Platzbedarf der Behandlungsanlage insgesamt und spezifisch der Substrattransporteinrichtung zu reduzieren, kann das Schleusenventil zwischen benachbarten Vakuumkammern, z.B. einer Substrataufnahmekammer und einer Substratbehandlungskammer, so ausgerichtet sein, dass seine Öffnung an einem Mittelpunkt des Bewegungskreisbogens des zugeordneten Schwenkarms zwischen dessen erster und zweiter Arbeitsposition liegt. Die Breite der Öffnung des Schleusenventils lässt sich bestmöglich ausnutzen, wenn das Schleusenventil so ausgerichtet ist, dass eine Tangente des Bewegungskreisbogens in diesem Mittelpunkt senkrecht auf einer durch die Breite der Öffnung des Schleusenventils definierten Geraden steht.

Ein Mittelpunkt der Öffnung des Schleusenventils, bezogen auf dessen Breite, kann mit dem Mittelpunkt des Bewegungskreisbogens zwischen der ersten Arbeitsposition (und damit der Substrathalterhaltevorrichtung) in der Substrataufnahmekammer und der zweiten Arbeitsposition (und damit der Substrathalterhaltevorrichtung) in der Substratbehandlungskammer zusammenfallen.

In der Substratbehandlungskammer ist beispielsweise eine Vorrichtung zum physikalischen und/oder chemischen Behandeln der optischen Substrate angeordnet. Die durch die Vorrichtung durchgeführte physikalische und/oder chemische Behandlung umfasst beispielsweise ein Beschichten, Bedampfen, Reinigen, Entfetten, Glimmen, Ausheilen und/oder Tempern oder auch andere geeignete Vorbehandlungen, Behandlungen und/oder Nachbehandlungen der optischen Substrate. Die Behandlung kann auf jede geeignete Art und Weise erfolgen, zum Beispiel mittels einer PVD-, CVD- oder PECVD-Einrichtung, durch eine Plasmabehandlung, durch Heizen und/oder Bestrahlen mit elektromagnetischer Strahlung oder Partikelstrahlung.

Es ist aber auch möglich, bestimmte Behandlungen der optischen Substrate, z.B. Vor- und/oder Nachbehandlungen, in einer der Substrataufnahmekammern durchzuführen. Hierbei kann es sich u.a. um eine thermische Behandlung oder eine Beschichtung bei Raumtemperatur handeln.

Der Substrathalter weist in einem Aspekt eine Oberseite und eine der Oberseite entgegengesetzte Unterseite auf, wobei die Kopplung des Schwenkarms mit dem Substrathalter an der Oberseite des Substrathalters erfolgt und die Vorrichtung zum physikalischen und/oder chemischen Behandeln der optischen Substrate der Unterseite des Substrathalters zugewandt ist. Auf diese Weise ist es möglich, durch den Substrathalter die Vorrichtung zumindest teilweise abzudichten, und so die Oberseite des Substrathalters und den Bereich der Substratbehandlungskammer oberhalb des Substrathalters z.B. gegen eine Beeinträchtigung durch die vorgenommene Behandlung der optischen Substrate abzuschirmen.

Der Schwenkarm ist dabei in einer Variante immer an der Oberseite des Substrathalters positioniert, während eine Behandlung der optischen Substrate immer von der Unterseite des Substrathalters her erfolgt. Eine Verunreinigung der optischen Substrate durch die Bewegung des Substrathalters oder z.B. die Koppelvorgänge mit dem Schwenkarm ist somit deutlich reduziert, genau wie eine Beeinträchtigung des Schwenkarms durch die Behandlung der optischen Substrate. Es wäre jedoch auch denkbar, die Substratbehandlungskammer und/oder den Substrathalter so auszulegen, dass die Behandlung der optischen Substrate von der Oberseite des Substrathalters her erfolgt.

Um den Schwenkarm besser beispielsweise durch die Schleusenventile zwischen einer Substrataufnahmekammer und einer benachbarten Substratbehandlungskammer zu bewegen, kann der Schwenkarm zwischen der Schwenkwelle und der Koppelvorrichtung gekrümmt verlaufen. Die Krümmung ist dabei normalerweise in der Schwenkebene ausgebildet. Der Schwenkarm kann z.B. zwei oder mehrere im Winkel zueinander verlaufende (geradlinige) Abschnitte aufweisen, wodurch sich insgesamt die Krümmung des Schwenkarms ergibt. Der Schwenkarm könnte aber auch abschnittsweise oder über die gesamte Länge kontinuierlich gekrümmt sein.

Um den Substrathalter mit dem Schwenkarm koppeln und vom Schwenkarm entkoppeln zu können, weist der Substrathalter beispielsweise wenigstens eine Koppelungsstruktur für die Koppelvorrichtung auf, wobei die Koppelvorrichtung dazu ausgelegt ist, mit der Koppelungsstruktur kraft- und/oder formschlüssig zusammenzuwirken, um den Substrathalter mit dem Schwenkarm zu koppeln, und von der Koppelungsstruktur gelöst zu werden, um den Substrathalter vom Schwenkarm zu entkoppeln.

In einer möglichen Variante ist die Koppelvorrichtung eine Gabel mit zwei parallelen Stegen, wobei die Stege parallel zur Schwenkebene und tangential zum Bewegungskreisbogen ausgerichtet sind. Die Koppelungsstruktur kann durch eine Platte am Substrathalter gebildet sein, die eine Aufnahme definiert, in die die Stege der Koppelvorrichtung eingreifen können, um den Substrathalter mit dem Schwenkarm zu koppeln, während die Stege aus der Aufnahme herausgezogen werden, um Substrathalter und Schwenkarm wieder zu entkoppeln. Die Koppelvorrichtung und die Koppelungsstruktur lassen sich aber auch auf jede andere geeignete Weise realisieren, beispielsweise durch eine andere mechanische Vorrichtung oder auch durch eine Magnetvorrichtung.

Wenn der Substrathalter einen zentralen Angriffspunkt für die Koppelvorrichtung des Schwenkarms aufweist, der insbesondere durch eine einzige Koppelungsstruktur gebildet ist, ist eine zentrale Fixierung des Schwenkarms am Substrathalter realisierbar, die einen einfachen und sicheren Transport des Substrathalters durch die Behandlungsanlage ermöglicht. Der zentrale Angriffspunkt kann der einzige Angriffspunkt sein, wodurch die Anzahl der sich mechanisch kontaktierenden Teile auf ein Minimum reduziert ist. So ist es z.B. einfach möglich, den Substrathalter hängend an der Koppelvorrichtung zu fixieren.

Der Substrathalter kann beispielsweise die Form einer Kalotte aufweisen, mit einer domförmigen Fläche, auf der die Halterungen für die optischen Substrate angeordnet sind. Andere Formen sind für den Substrathalter auch denkbar. Beispielsweise könnte der Substrathalter plattenförmig sein, einen Haltekäfig bilden, in den etliche optische Substrate eingestellt sind, oder ein Gestell umfassen, in das optische Substrate eingehängt sind. In jeder Form kann der Substrathalter beispielsweise etwa 10 bis 150 Halterungen für jeweils ein optisches Substrat aufweisen.

Um den Substrathalter an geeigneten Stellen in der Behandlungsanlage ablegen oder aufhängen zu können, wenn der Substrathalter vom Schwenkarm entkoppelt ist, beispielsweise an der zweiten Arbeitsposition in der Substratbehandlungskammer, umfasst die Substrattransporteinrichtung beispielsweise zumindest an der zweiten Arbeitsposition in der Substratbehandlungskammer eine Substrathalterhaltevorrichtung, die dazu ausgelegt ist, mit dem Substrathalter zu koppeln und den Substrathalter positionsfest festzuhalten. Der Schwenkarm kann in diesem Fall den Substrathalter an die Substrathalterhaltevorrichtung übergeben, wo er in der gewünschten Position sicher gehalten ist, während sich der Schwenkarm zurückbewegt.

Beispielsweise wird die Koppelungsstruktur am Substrathalter dazu verwendet, um den Substrathalter mit der Substrathalterhaltevorrichtung zu verbinden.

Die Substrathalterhaltevorrichtung weist in diesem Fall eine geeignete Halterung für den Substrathalter auf, z.B. ein Greifelement, das an der Koppelungsstruktur angreift, um den Substrathalter mit der Substrathalterhaltevorrichtung zu koppeln und das die Koppelungsstruktur freigibt, um die Substrathalterhaltevorrichtung wieder vom Substrathalter zu entkoppeln. Die Angriffsstellen für die Koppelvorrichtung am Schwenkarm und für die Substrathalterhaltevorrichtung sind normalerweise an räumlich getrennten Positionen der Kuppelungsstruktur realisiert, damit der Schwenkarm und die Substrathalterhaltevorrichtung gleichzeitig mit dem Substrathalter gekoppelt sein können.

Die Substrathalterhaltevorrichtung kann dazu ausgelegt sein, den Substrathalter um eine Achse senkrecht zur Schwenkebene des Schwenkarms zu rotieren und/oder in einer Richtung senkrecht zur Schwenkebene zu verfahren. Eine Drehung des Substrathalters lässt sich beispielsweise dazu nutzen, den Substrathalter korrekt für eine Übernahme durch einen Schwenkarm zu positionieren. Der Substrathalter kann auch während einer Behandlung der optischen Substrate rotiert werden, um eine gleichförmigere Behandlung zu erreichen und z.B. eine gleichmäßigere Beschichtung zu erhalten. Die Substrathalterhaltevorrichtung nimmt außerdem in der Regel die mechanischen Kräfte während des Koppelns und Entkoppelns des Substrathalters mit dem Schwenkarm auf.

In einer Variante ist nur die Substrathalterhaltevorrichtung in der Substratbehandlungskammer drehbar ausgelegt, um etwa eine Rotation des Substrathalters während der Substratbehandlung zu ermöglichen, während die Substrathalterhaltevorrichtungen in den Substrataufnahmekammern nicht drehbar sind. In diesem Fall können die Substrathalterhaltevorrichtungen in den Substrataufnahmekammern indiziert sein, z.B. im 120°-Winkel, um die Koppelung mit dem Schwenkarm zu vereinfachen.

Beispielsweise ist die Substrathalterhaltevorrichtung innen an einer Oberseite der jeweiligen Vakuumkammer positioniert.

Es ist möglich, an jeder Arbeitsposition eine Substrathalterhaltevorrichtung anzuordnen, sodass es an jeder Arbeitsposition möglich ist, den Substrathalter ohne zusätzliche bewegte Komponenten vom Schwenkarm zu entkoppeln.

Wenn das Beladen und/oder Entladen des Substrathalters in eine Substrataufnahmekammer nicht direkt auf einen oder von einem Schwenkarm erfolgt, kann eine Substrathalterhaltevorrichtung auch dazu genutzt werden, einen Substrathalter mittels einer externen Vorrichtung durch ein Schleusenventil zum Beladen oder Entladen in die oder aus der Substrataufnahmekammer zu bewegen und mit der Substrathalterhaltevorrichtung zu koppeln oder entsprechend zu entkoppeln.

Die Substrattransporteinrichtung kann allgemein so ausgebildet sein, dass die Substrathalterhaltevorrichtung und zumindest die Koppelvorrichtung des Schwenkarms in einer Richtung senkrecht zur Schwenkebene des Schwenkarms relativ zueinander beweglich sind. Die Relativbewegung beträgt z.B. mehr als 10 mm und/oder weniger als 100 mm.

Hierzu kann die Substrathalterhaltevorrichtung und/oder die Schwenkwelle des Schwenkarms verschiebbar ausgebildet sein, oder die Koppelvorrichtung in der Richtung senkrecht zur Schwenkebene beweglich, beispielsweise verkippbar, ausgebildet sein.

Die Relativbewegung senkrecht zur Schwenkebene des Schwenkarms hat den Vorteil, dass so eine einfache Kopplung zwischen der Substrathalterhaltevorrichtung und der Koppelungsstruktur des Substrathalters möglich ist. Dies kann durch eine Drehbeweglichkeit der Substrathalterhaltevorrichtung noch unterstützt werden.

Wenn die Substrathalterhaltevorrichtung bewegbar ist, kann der Substrathalter in der Substratbehandlungskammer aus der Schwenkebene des Schwenkarms ein Stück abgesenkt werden, um in eine geeignete Position bezüglich der Behandlungsvorrichtung in der Substratbehandlungskammer gebracht zu werden.

Alle Antriebe der Substrattransporteinrichtung lassen sich außerhalb der Vakuumkammern in nicht evakuierten Bereichen der Behandlungsanlage anordnen, was die Behandlungsanlage deutlich vereinfacht und Kontaminationen durch Partikel im Inneren der Vakuumkammer erheblich reduziert. Dies hat auch den Vorteil, dass sich die Antriebe z.B. im Grauraum befinden können.

Beispielsweise ist die Schwenkbewegung des Schwenkarms über eine einfache Drehdurchführung der Schwenkwelle in der jeweiligen Substrataufnahmekammer realisierbar. Für die Substrathalterhaltevorrichtung kann eine Drehdurchführung an der Oberseite der jeweiligen Vakuumkammer verwendet werden, gegebenenfalls verbunden mit einer Lineardurchführung, wenn die Substrathalterhaltevorrichtung senkrecht zur Schwenkebene des Schwenkarms bewegt werden soll. Derartige Komponenten bieten eine sichere, einfache und kostengünstige Möglichkeit, die Schwenkwelle oder Substrathalterhaltevorrichtung außerhalb der Vakuumkammer mit einem Antrieb zu koppeln.

Wenn die Substratbehandlungskammer eine Servicetür aufweist, die einen Zugang zu einem Inneren der Substratversorgungkammer ermöglicht, ist z.B. eine Wartung der Vorrichtung zum physikalischen und/oder chemischen Behandeln der optischen Substrate einfach möglich. In einer möglichen Variante ist die Servicetür so angeordnet, dass sie in den Grauraum öffnet, was die Servicearbeiten vereinfacht und verhindert, dass für Servicearbeiten der Reinraum genutzt werden muss, über den die Substrathalter in die Behandlungsanlage be- und entladen werden.

Ferner betrifft die Erfindung einen Koppelmechanismus, insbesondere dessen Verwendung bei einer Behandlungsanlage der zuvor genannten Art. Der Koppelmechanismus umfasst eine Koppelvorrichtung, eine an einem Substrathalter vorgesehene Koppelungsstruktur sowie eine Substrathalterhaltevorrichtung. Die Koppelungsstruktur ist eingerichtet, sowohl mit der Koppelvorrichtung als auch mit der Substrathalterhaltevorrichtung zusammenzuwirken, sodass der Substrathalter über die Koppelungsstruktur in einem ersten Zustand mit der Substrathalterhaltevorrichtung und in einem zweiten Zustand mit der Koppelvorrichtung gekoppelt ist. Insbesondere können der erste Zustand und der zweite Zustand gleichzeitig vorliegen, sodass die Koppelungsstruktur gleichzeitig mit der Koppelvorrichtung und der Substrathalterhaltevorrichtung gekoppelt ist. In einfacher Weise lassen sich die entsprechenden Koppelungen durch Stifte und Öffnungen realisieren, in die die zugeordneten Stifte eingreifen.

Wenn der Koppelmechanismus auch dazu ausgelegt ist, mit der Koppelvorrichtung des Schwenkarms zusammenzuwirken, hat dies den Vorteil, dass der an der Substrathalterhaltevorrichtung fixierte Substrathalter einfach vom Schwenkarm entkoppelbar und mit dem Schwenkarm koppelbar ist.

Weiterhin betrifft die Erfindung ein Verfahren zum Betrieb einer Behandlungsanlage für optische Substrate, die insbesondere wie oben beschrieben ausgebildet ist. Die Behandlungsanlage umfasst wenigstens eine Substrataufnahmekammer und wenigstens eine Substratbehandlungskammer sowie eine Substrattransporteinrichtung mit wenigstens einem Schwenkarm, wobei die Substrattransporteinrichtung dazu ausgelegt ist, einen Substrathalter mit einer Vielzahl von Halterungen für zu behandelnde optische Substrate zwischen der Substrataufnahmekammer und der Substratbehandlungskammer zu bewegen, sowie einen Koppelmechanismus, der eine am Schwenkarm angerordnete Koppelvorrichtung, eine am Substrathalter vorgesehene Koppelungsstruktur sowie eine Substrathalterhaltevorrichtung umfasst. Das Verfahren umfasst die folgenden Schritte:
- Beladen des Substrathalters aus einem nicht evakuierten Bereich in die Substrataufnahmekammer und Koppeln des Substrathalters mit der Substrathalterhaltevorrichtung in der Substrataufnahmekammer, und
- Koppeln des Substrathalters mit dem Schwenkarm in der Substrataufnahmekammer.

Das Entladen des Substrathalters aus der Substrataufnahmekammer erfolgt nach einem weiteren Aspekt dementsprechend in umgekehrter Reihenfolge der zuvor genannten Verfahrensschritte.

In einer möglichen Variante wird das Verfahren fortgesetzt, um den Substrathalter durch den Schwenkarm in die Substratbehandlungskammer zu bewegen, dort die optischen Substrate zu behandeln und anschließend den Substrathalter durch den Schwenkarm in die Substrataufnahmekammer zurückzubewegen oder optional den Substrathalter durch den Schwenkarm einer weiteren, ebenfalls an die Substratbehandlungskammer angrenzenden Substrataufnahmekammer in diese weitere Substrataufnahmekammer zu überführen.

Von der jeweiligen Substrataufnahmekammer wird der Substrathalter dann in den nicht evakuierten Bereich entladen.

Dabei kann der Substrathalter in jeder Vakuumkammer jeweils zuerst mit der Substrathalterhaltevorrichtung gekoppelt und dann vom Schwenkarm entkoppelt bzw. mit dem Schwenkarm gekoppelt werden. Die Substrathalterhaltevorrichtung dient jeweils als Fixierung, um den Substrathalter während des Koppelns und Entkoppelns mit der Koppelvorrichtung des Schwenkarms festzuhalten.

In einem weiteren optionalen Verfahrensschritt wird der Substrathalter durch die Substrathalterhaltevorrichtung während der Behandlung der Substrate in Drehung um eine Rotationsachse senkrecht zur Schwenkebene des Schwenkarms versetzt.

Die Merkmale aller beschriebenen Varianten lassen sich im Ermessen des Fachmanns nach Belieben miteinander kombinieren und gegeneinander austauschen. Insbesondere können der beschriebene Koppelmechanismus und/oder das beschriebene Be- und Entladeverfahren auch in anderen Anlagen als der hier beschriebenen eingesetzt werden.

Die Erfindung wird nachfolgend anhand eines Ausführungsbeispiels mit Bezug auf die beigefügten Figuren näher beschrieben. In den Figuren zeigen:
- Figur 1 eine schematische Darstellung einer erfindungsgemäßen Behandlungsanlage;
- Figur 2 einen Ausschnitt aus Figur 1 in einer anderen Perspektive;
- Figur 3 weitere Details der Behandlungsanlage aus Figur 1;
- Figur 4 eine schematische Darstellung einer Möglichkeit zur Erweiterung der Behandlungsanlage aus Figur 1;
- Figur 5 eine Perspektivansicht der Behandlungsanlage nach Figur 1 mit geöffneter Servicetür;
- Figur 6 eine Draufsicht auf die Behandlungsanlage nach Figur 1, wobei nur ein Schwenkarm gezeigt ist;
- Figur 7 eine Detailansicht der Koppelung mittels der Koppelvorrichtung;
- Figur 8 eine Schnittansicht eines Details der Figur 7; und
- Figur 9 eine Rückansicht der Behandlungsanlage nach Figur 1 mit zusätzlichen Funktionalitäten.

Aus Gründen der Übersichtlichkeit sind nicht immer alle identischen Komponenten mit Bezugszeichen versehen.

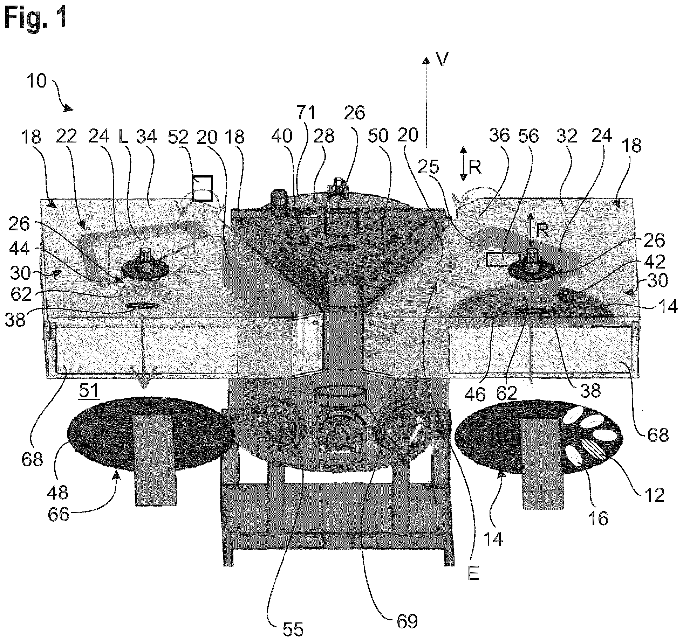

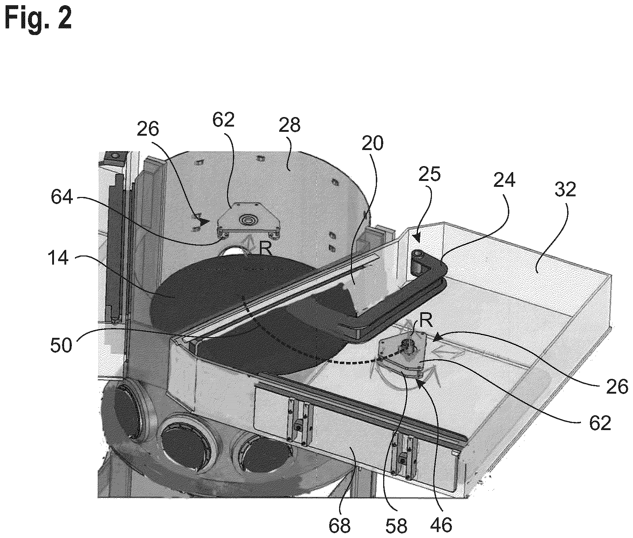

Die Figuren 1 bis 3 zeigen eine Behandlungsanlage 10 für optische Substrate 12 (angedeutet in Figur 1), die auf einem Substrathalter 14 aufgenommen sind.

Die Behandlungsanlage 10 dient beispielsweise dazu, die optischen Substrate 12 physikalisch und/oder chemisch zu behandeln, beispielsweise mit einer geeigneten Beschichtung zu versehen, sowie optional alle dazu notwendigen weiteren Behandlungsschritte, z.B. Vor- und Nachbehandlungen, beispielsweise eine thermische Behandlung oder eine Reinigung, durchzuführen.

Die optischen Substrate 12 sind in diesem Beispiel zur Herstellung von Konsumerprodukten bestimmt, z.B. Brillenglassubstrate für Sehhilfen, Sportbrillen und Sonnenbrillen, oder auch flächige Substrate für brillenähnliche Vorrichtungen für virtuelle oder erweiterte Realität. Es können aber z.B. auch flächige Substrate etwa für ein Heads Up-Display oder für optische Filter sein.

Der Substrathalter 14 weist hier eine Vielzahl von Halterungen 16 auf, beispielsweise 10 bis 150, wobei in jeder Halterung 16 ein optisches Substrat 12 aufgenommen und auf geeignete Art fixiert ist. Ein Substrathalter 14 wird jeweils mit sämtlichen darauf montierten optischen Substrate 12 einzeln in die Behandlungsanlage 10 eingebracht und aus dieser wieder entnommen, sodass innerhalb der Behandlungsanlage ein einzelnes optisches Substrat 12 nie alleine, sondern immer nur der gesamte Substrathalter 14 mit allen darauf angeordneten Substraten 14 zusammen bewegt wird. In einer nicht dargestellten Variante kann der Substrathalter 14 auch nur eine einzige Halterung 16, z.B. für ein sehr großes Substrat 12, aufweisen.

Die Behandlungsanlage 10 umfasst in diesem Beispiel drei Vakuumkammern 18, die in einer Reihe angeordnet sind, wobei benachbarte Vakuumkammern 18 jeweils über ein Schleusenventil 20 miteinander verbunden sind. Das Schleusenventil 20 bildet einen verschließbaren Durchgang zwischen den benachbarten Vakuumkammern 18 und ist so ausgelegt, dass ein Substrathalter 14 durch eine Öffnung des Schleusenventils 20 von einer Vakuumkammer 18 in eine benachbarte Vakuumkammer 18 bewegt werden kann.

Um den Substrathalter 14 durch die Vakuumkammern 18 der Behandlungsanlage 10 zu bewegen, weist die Behandlungsanlage 10 eine Substrattransporteinrichtung 22 auf. Die Substrattransporteinrichtung 22 umfasst hier zwei Schwenkarme 24 sowie in jeder Vakuumkammer 18 eine Substrathalterhaltevorrichtung 26.

Im gezeigten Beispiel bildet die mittlere Vakuumkammer 18 eine Substratbehandlungskammer 28, während die beiden äußeren, in Figur 1 der Substratbehandlungskammer 28 rechts und links benachbarten Vakuumkammern 18 jeweils eine Substrataufnahmekammer 30 bilden, hier als erste Substrataufnahmekammer 32 und als zweite Substrataufnahmekammer 34 bezeichnet.

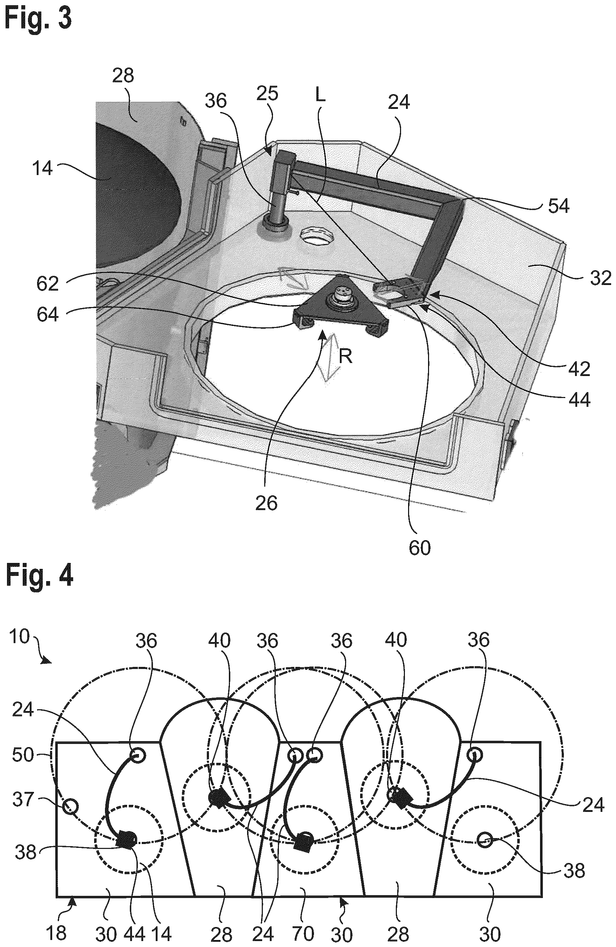

Prinzipiell kann die Behandlungsanlage 10 eine beliebige Anzahl von Vakuumkammern 18 in Form von Substrataufnahmekammern 30 und Substratbehandlungskammern 28 umfassen (siehe Figur 4).

Sowohl in der ersten Substrataufnahmekammer 32 als auch in der zweiten Substrataufnahmekammer 34 ist jeweils eine Schwenkwelle 36 angeordnet, an der jeweils ein Schwenkarm 24 mit einem ersten Ende 25 so fixiert ist, dass er durch eine Drehung der Schwenkwelle 36 zwischen einer ersten Arbeitsposition 38 in der jeweiligen Substrataufnahmekammer 32, 34 und einer zweiten Arbeitsposition 40 in der benachbarten Substratbehandlungskammer 28 verschwenkbar ist.

Die Schwenkwelle 36 definiert eine Richtung R senkrecht zu einer Schwenkebene E des Schwenkarms 24. Die Richtung R fällt hier mit der Vertikalen V zusammen, sodass die Schwenkebene E horizontal liegt.

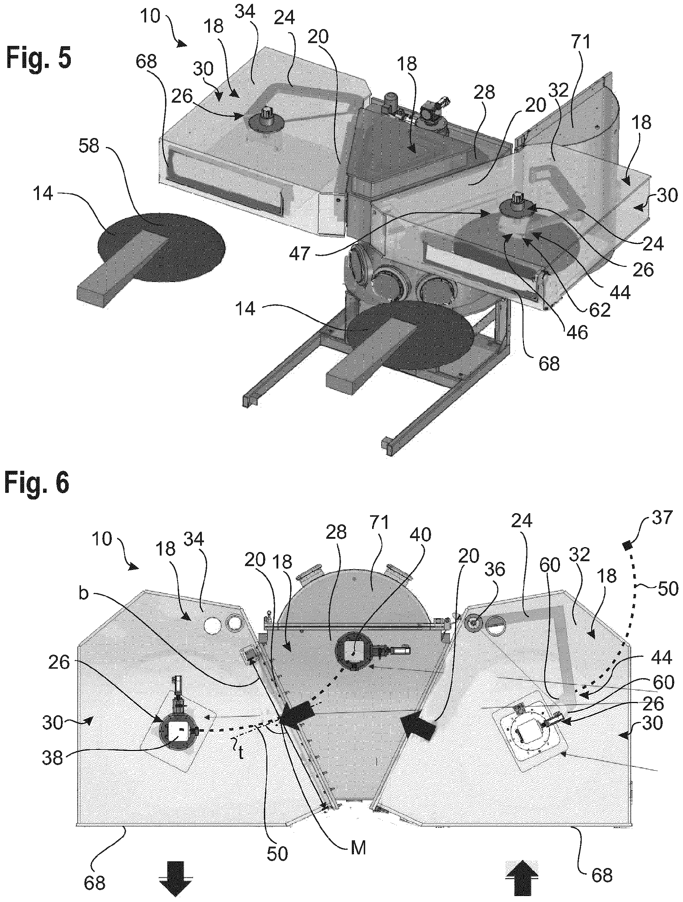

Die Behandlungsanlage 10 ist optional so ausgelegt, dass zumindest einer der Schwenkarme 24 eine oder mehrere weitere Arbeitspositionen 37 beispielsweise in einer der Substrataufnahmekammern 32, 34 anfahren kann (siehe z.B. Figur 4). Ebenso ist es möglich, dass eine (nicht dargestellte) Zugangstür der Substrataufnahmekammern 32, 34, welche beispielsweise entgegengesetzt zum jeweiligen Schleusenventil 20 vorgesehen ist, geöffnet wird, sodass der jeweilige Schwenkarm 24 aus der entsprechenden Substrataufnahmekammer 32, 34 in eine weitere Arbeitsposition 37 herausgeschwenkt wird, wie dies in Figur 6 mit der gestrichelten Linie für den dort gezeigten Schwenkarm 24 angedeutet ist.

Jeder Schwenkarm 24 weist an seinem zweiten Ende 42 eine Koppelvorrichtung 44 auf, die dazu dient, den Schwenkarm 24 mit dem Substrathalter 14 zu koppeln, um den Substrathalter 14 durch die Behandlungsanlage 10 zu bewegen.

Hierzu weist der Substrathalter 14 eine Koppelungsstruktur 46 auf, die mit der Koppelvorrichtung 44 des Schwenkarms 24 kraft- und/oder formschlüssig zusammenwirken kann, um den Substrathalter 14 und den Schwenkarm 24 miteinander zu koppeln, und die von der Koppelvorrichtung 44 gelöst werden kann, wenn der Schwenkarm 24 vom Substrathalter 14 entkoppelt werden soll.

Die Koppelungsstruktur 46 bildet hier einen einzigen, zentralen Angriffspunkt am Substrathalter 14 für die Koppelvorrichtung 44 des Schwenkarms 24.

Die Koppelungsstruktur 46, die Koppelvorrichtung 44 und die Substrathalterhaltevorrichtung 26 bilden gemeinsam einen Koppelmechanismus 47 aus.

In dem gezeigten Beispiel ist die Koppelungsstruktur 46 an einer Oberseite 48 des Substrathalters 14 und mittig am Substrathalter 14 angeordnet. Der Schwenkarm 24 befindet sich daher stets oberhalb der Oberseite 48 des Substrathalters 14 und hängt hier unterhalb des Schwenkarms 24.

Alternativ zum kraft- und/oder formschlüssigen Zusammenwirken der Koppelvorrichtung 44 und der Koppelungsstruktur 46 kann auch z.B. ein (elektro-)magnetisches Halten bzw. Koppeln vorgesehen sein.

Die Behandlungsanlage 10 ist hier so ausgelegt, dass an jeder Arbeitsposition 38, 40 der Schwenkarm 24 mit dem Substrathalter 14 gekoppelt und vom Schwenkarm 24 entkoppelt werden kann.

Hierzu ist in diesem Beispiel an jeder Arbeitsposition 38, 40 auch eine Substrathalterhaltevorrichtung 26 vorgesehen. Die Substrathalterhaltevorrichtung 26 ist so ausgelegt, dass sie mit der Koppelungsstruktur 46 am Substrathalter 14 zusammenwirken kann, um den Substrathalter 14 mit der Substrathalterhaltevorrichtung 26 zu verbinden und dort positioniert zu halten. Dies entspricht einem ersten Zustand des Koppelmechanismus 47. In diesem Zustand kann die Koppelvorrichtung 44 am Schwenkarm 24 vom Substrathalter 14 gelöst und somit der Schwenkarm 24 vom Substrathalter 14 entkoppelt und vom Substrathalter 14 entfernt werden. Genauso kann in diesem Zustand die Koppelvorrichtung 44 mit dem Substrathalter 14 verbunden und so der Schwenkarm 24 mit dem Substrathalter 14 gekoppelt werden, was dem zweiten Zustand des Koppelmechanismus 47 entspricht.

Insofern kann die Koppelungsstruktur 46 derart ausgebildet sein, dass sowohl der erste Zustand als auch der zweite Zustand gleichzeitig vorliegen. Mit anderen Worten kann der Substrathalter 14 über die Koppelungsstruktur 46 gleichzeitig mit der Koppelvorrichtung 44 am Schwenkarm 24 sowie mit der Substrathalterhaltevorrichtung 26 gekoppelt sein.

Die Koppelvorrichtung 44 bewegt sich beim Verschwenken des Schwenkarms 24 auf einem Bewegungskreisbogen 50, auf dem auch alle Arbeitspositionen 38, 40 liegen.

Beide Schwenkarme 24 sind hier spiegelbildlich zueinander ausgebildet, aber ansonsten in Form und Größe identisch, sodass ihre Bewegungskreisbögen 50 den gleichen Radius haben.

Die Schwenkarme 24 sind in sich starr und verändern während ihrer Schwenkbewegung weder ihre Länge L zwischen dem ersten und dem zweiten Ende 25, 42, noch ihre Krümmung.

Beispielsweise weist der Schwenkarm 24 einen profilierten Querschnitt auf, etwa in Form eines I- oder Doppel-T-Profils.

Wie beispielsweise in Figur 3 zu erkennen ist, wird die Krümmung des Schwenkarms 24 in diesem Beispiel erzeugt, indem mehrere geradlinige Abschnitte des Schwenkarms 24 in einem Winkel aneinandergrenzen. Die Krümmung des Schwenkarms 24 könnte aber auch durch eine andere geometrische Form erreicht werden.

Im Wesentlichen bestimmen sich die Länge L und die Krümmung des Schwenkarms 24 im Ermessen des Fachmanns aus der Position der Schwenkwelle 36 in der jeweiligen Substrataufnahmekammer 30, 32, 34, einer Breite des Schleusenventils 20 und des Abstands der Arbeitspositionen 38, 40 so, dass der Schwenkarm 24 beide Arbeitspositionen 38, 40 erreichen und dabei den Substrathalter 14 durch das Schleusenventil 20 bewegen kann.

Die Schwenkwelle 36 ist mit einem außerhalb der Vakuumkammer 18 in einem nicht evakuierten Bereich 51 der Behandlungsanlage 10 angeordneten geeigneten Antrieb 52 verbunden, der dazu ausgelegt ist, die Schwenkwelle 36 zu drehen. Beispielsweise handelt es sich hier um einen Elektromotor an einer bekannten Drehdurchführung, die mit der Schwenkwelle 36 verbunden ist.

In diesem Beispiel steht jede der Vakuumkammern 18 mit wenigstens einer geeigneten Vakuumpumpe über einen Anschlussflansch 55 in Strömungsverbindung, um sie bis zu einem gewünschten Unterdruck zu evakuieren (hier nur für die Substratbehandlungskammer 28 gezeigt).

Die Substrathalterhaltevorrichtung 26 ist in diesem Beispiel so ausgebildet, dass sie den Substrathalter 14 in der Schwenkebene E drehen kann, hier sowohl, um die Koppelungsstruktur 46 an die Position der Koppelvorrichtung 44 am Schwenkarm 24 anzupassen, als auch, um während einer Behandlung der optischen Substrate 12 in der Substratbehandlungskammer 28 den Substrathalter 14 in Rotation zu versetzen. In einer nicht dargestellten Variante ist nur die Substrathalterhaltevorrichtung 26 in der Substratbehandlungskammer 28 drehbar ausgelegt, während die Substrathalterhaltevorrichtungen 26 in den Substrataufnahmekammern 30, 32 starr in der jeweiligen Vakuumkammer fixiert sind.

Weiterhin ist die Substrathalterhaltevorrichtung 26 hier so ausgebildet, dass sie den Substrathalter 14 entlang der Richtung R, also senkrecht zur Schwenkebene E der Schwenkarms 24, um ein vorgegebenes Maß verschieben kann. Die Verschiebung beträgt beispielsweise mehr als 10 mm und/oder weniger als 100 mm, insbesondere etwa zwischen 10 mm und 100 mm.

Ein geeigneter Antrieb 56 der Substrathalterhaltevorrichtung 26 befindet sich außerhalb der Vakuumkammer 18 in einem nicht evakuierten Bereich 51 der Behandlungsanlage 10.

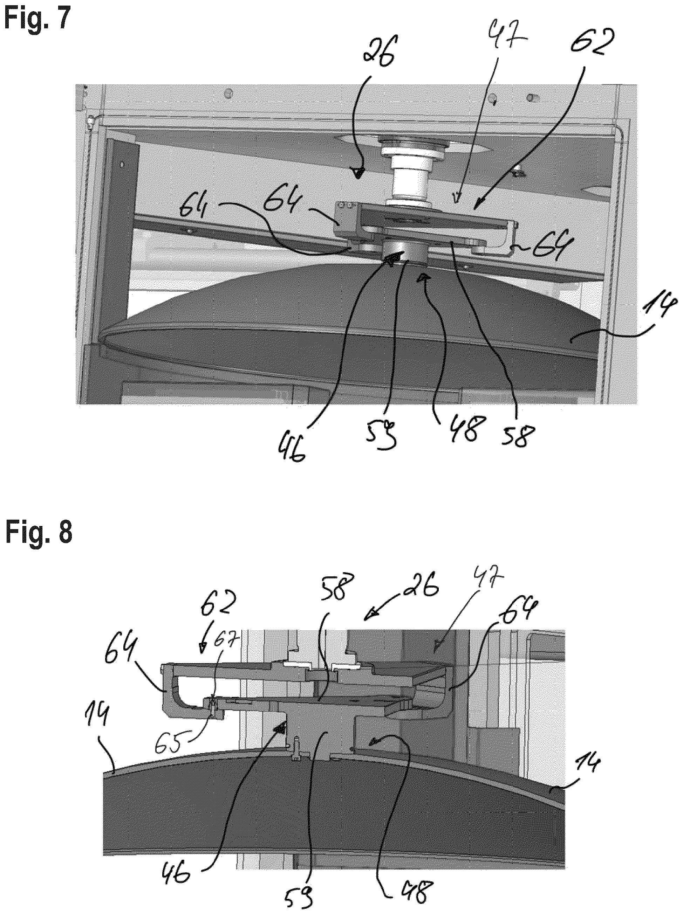

Die Koppelungsstruktur 46 am Substrathalter 14 ist beispielsweise durch eine dreieckige Platte 58 gebildet, die über einen mittig an der Platte angeordneten Flansch 59 mit der Oberseite 48 des Substrathalters 14 fest verbunden ist, sodass eine Aufnahme für die Koppelvorrichtung 44 gebildet ist, wie dies aus den Figuren 7 und 8 deutlich wird.

Die Koppelvorrichtung 44 am Ende 42 des Schwenkarms 24 umfasst hier zwei unbewegliche, parallele Stege 60, die in ausreichendem Abstand zueinander angeordnet sind, um den Flansch 59 der Koppelungsstruktur 46 zu umgreifen bzw. zwischen sich aufzunehmen und an einer Unterseite der Platte 58 anzugreifen.

Zum Koppeln des Schwenkarms 24 mit dem Substrathalter 14 werden die Stege 60 der Koppelvorrichtung 44 so unter die Platte 58 geschoben, dass sie den Flansch 59 umgreifen und unterhalb der Platte 58 liegen. Es ist natürlich auch möglich, einen anderen geeigneten Angriffspunkt zu wählen, z.B. direkt am Flansch 59 oder an einer weiteren, an der Platte 58 ausgebildeten Struktur.

Anschließend kann der Substrathalter 14 über die Substrathalterhaltevorrichtung 26 in Vertikalrichtung V abgesenkt werden, um das Koppeln mit der Koppelvorrichtung 44 zu ermöglichen.

Hierbei können an der Koppelvorrichtung 44 vorgesehene Stifte in Öffnungen der Koppelungsstruktur 46, insbesondere der Platte 58, eingreifen. Die Koppelvorrichtung 44 ist hierdurch mit der Koppelungsstruktur 46 gekoppelt.

Der Substrathalter 14 wird bei der hier dargestellten hängenden Fixierung durch die Wirkung der Schwerkraft stabilisiert.

Zum Entkoppeln erfolgt das Prozedere in umgekehrte Richtung, da der Substrathalter 14 über die Substrathalterhaltevorrichtung 26 in Vertikalrichtung V angehoben wird, wodurch die an der Koppelvorrichtung 44 vorgesehenen Stifte nicht mehr in den Öffnungen der Koppelungsstruktur 46, insbesondere der Platte 58, eingreifen.

Anschließen kann der Schwenkarm 24 in Gegenrichtung bewegt und die Stege 60 der Koppelvorrichtung 44 wieder aus der Aufnahme unter der Platte 58 herausgezogen werden.

Die Substrathalterhaltevorrichtung 26 weist hierzu ein Greifelement 62 mit beispielsweise drei nach unten abstehenden Haken 64 auf, die durch eine Dreh-und/oder Lateralbewegung der Substrathalterhaltevorrichtung 26 in Eingriff mit der Platte 58 der Kopplungsstruktur 46 gebracht werden können und so die Koppelungsstruktur 46 mit der Substrathalterhaltevorrichtung 26 verbinden können (siehe Figuren 3, 4, 7 und 8).

Insbesondere sind an den Haken 64 ebenfalls Stifte 65 vorgesehen, die in korrespondierende Öffnungen 67 in der Kopplungsstruktur 46 eingreifen, insbesondere der Platte 58, um die Koppelung zwischen der Substrathalterhaltevorrichtung 26 und der Kopplungsstruktur 46 herzustellen, wie aus Figur 8 deutlich wird.

Wir vorstehend schon erläutert, kann die Kopplungsstruktur 46 gleichzeitig mit der Substrathalterhaltevorrichtung 26 sowie mit der Koppelvorrichtung 44 gekoppelt sein, weswegen die Kopplungsstruktur 46 entsprechende Öffnungen für die Stifte 65 der Substrathalterhaltevorrichtung 26, insbesondere der Haken 64, sowie für die Stifte der Koppelvorrichtung 44 aufweist.

Zum Entkoppeln des Substrathalters 14 von der Substrathalterhaltevorrichtung 26 wird zunächst die Kopplungsstruktur 46 mit der Koppelvorrichtung 44 gekoppelt, indem der Substrathalter 14 von der Substrathalterhaltevorrichtung 26 angehoben wird, sodass die Koppelvorrichtung 44 über den Schwenkarm 24 eingeschwenkt werden kann.

Anschließend wird der Substrathalter 14 von der Substrathalterhaltevorrichtung 26 in vertikale Richtung abgesenkt, sodass die Stifte der Koppelvorrichtung 44 in die entsprechenden Öffnungen der Kopplungsstruktur 46 eingreifen. In dem Zustand ist der Substrathalter 14 über die Kopplungsstruktur 46 sowohl mit der Koppelvorrichtung 44 als auch mit der Substrathalterhaltevorrichtung 26 gekoppelt.

Danach kann die Substrathalterhaltevorrichtung 26 weiter abgesenkt werden, sodass die Stifte 65 der Substrathalterhaltevorrichtung 26, insbesondere der Haken 64, aus den Öffnungen 67 der Kopplungsstruktur 46 gezogen werden. Der Substrathalter 14 verbleibt hierbei in seiner Position, da der Substrathalter 14 mit der Koppelvorrichtung 44 gekoppelt ist.

Danach kann die Substrathalterhaltevorrichtung 26 so weit gedreht werden, dass die Platte 58 der Koppelungsstruktur 46 wieder freigegeben ist.

Da die Substrathalterhaltevorrichtung 26 entlang der Richtung R verschieblich ausgebildet ist, ist eine Relativbewegung zwischen der Koppelvorrichtung 44 und der Substrathalterhaltevorrichtung 26 entlang der Richtung R möglich. Eine derartige Relativbewegung kann alternativ zumindest teilweise durch eine Verschiebung der Schwenkwelle 36 oder des Schwenkarms 24 entlang der Richtung R oder einer Bewegung der Koppelvorrichtung 44 entlang der Richtung R erzeugt werden.

Die Koppelvorrichtung 44, die Koppelungsstruktur 46 und das Greifelement 62 sind hier nur beispielhaft beschrieben und können auf jede geeignete Art ausgebildet sein und beispielsweise neben mechanischen auch (elektro-)magnetische Elemente umfassen.

Nachfolgend wird erläutert, wie ein optisches Substrat 12 mittels der Behandlungsanlage 10 behandelt wird, wobei unter anderem auf die Figuren 1, 2, 3 und 6 Bezug genommen wird.

Um die optischen Substrate 12 auf dem Substrathalter 14 in der Behandlungsanlage 10 zu behandeln, wird zunächst der Substrathalter 14 mit einer Vielzahl von optischen Substraten 12 bestückt, indem die optischen Substrate 12 in ihre Halterungen 16 auf dem Substrathalter 14 eingelegt werden.

Die erste Substrataufnahmekammer 32 dient in diesem Beispiel als Beladekammer und weist ein weiteres Schleusenventil 68 an ihrer Außenseite auf. Dieses Schleusenventil 68 wird geöffnet, wobei gegebenenfalls vorher die erste Substrataufnahmekammer 32 belüftet wird.

Das Schleusenventil 20 zwischen der Substratbehandlungskammer 28 und der ersten Substrataufnahmekammer 32 ist in diesem Arbeitsschritt geschlossen.

Der Substrathalter 14 wird auf geeignete Weise durch das Schleusenventil 68 in die erste Substrataufnahmekammer 32 eingeführt und mit der Substrathalterhaltevorrichtung 26 an der ersten Arbeitsposition 38 gekoppelt. Etwaige Transporteinrichtungen, die zur Bewegung des Substrathalters 14 verwendet werden, werden wieder aus der ersten Substrataufnahmekammer 32 entfernt. Das Schleusenventil 68 wird geschlossen und die erste Substrataufnahmekammer 32 gegebenenfalls wieder evakuiert (wenn sie vorher belüftet wurde).

Jetzt wird der Schwenkarm 24 in der ersten Substrataufnahmekammer 32 zur ersten Arbeitsposition 38 bewegt, indem die Schwenkwelle 36 gedreht wird. Die Koppelvorrichtung 44 koppelt dann mit der Koppelungsstruktur 46 am Substrathalter 14, um den Schwenkarm 24 mit dem Substrathalter 14 zu koppeln. In diesem Arbeitsschritt ist der Substrathalter 14 auch noch mit der Substrathalterhaltevorrichtung 26 gekoppelt.

Jetzt wird die Koppelungsstruktur 46 am Substrathalter 14 von der Substrathalterhaltevorrichtung 26 getrennt und so der Substrathalter 14 von der Substrathalterhaltevorrichtung 26 entkoppelt. Der Substrathalter 14 ist dann nur noch mit dem Schwenkarm 24 über die Koppelvorrichtung 44 gekoppelt.

Die Substrathalterhaltevorrichtung 26 wird optional bewegt, z.B. ein Stück nach oben gezogen, um eine Bewegung des Schwenkarms 24 in Richtung zur Substratbehandlungskammer 28 freizugeben.

Das Schleusenventil 20 zwischen der ersten Substrataufnahmekammer 32 und der Substratbehandlungskammer 28 wird geöffnet, und der Schwenkarm 24 wird zusammen mit dem daran gekoppelten Substrathalter 14 zur zweiten Arbeitsposition 40 in die (evakuierte) Substratbehandlungskammer 28 verschwenkt.

Hier wird die Koppelungsstruktur 46 am Substrathalter 14 mit der Substrathalterhaltevorrichtung 26 in der Substratbehandlungskammer 28 gekoppelt und anschließend der Schwenkarm 24 vom Substrathalter 14 entkoppelt und in die erste Substrataufnahmekammer 32 zurück verschwenkt. Das Schleusenventil 20 zwischen der ersten Substrataufnahmekammer 32 und der Substratbehandlungskammer 28 wird wieder geschlossen.

In diesem Beispiel wird der Substrathalter 14 jetzt ein Stück aus der Schwenkebene E nach unten bewegt, indem die Substrathalterhaltevorrichtung 26 den Substrathalter 14 entlang der Richtung R verschiebt. Hierdurch wird optional eine Abdichtung zwischen einem Rand des Substrathalters 14 und einem Abschnitt der Substratbehandlungskammer 28 geschaffen, in dem eine oder mehrere Vorrichtungen 69 zum physikalischen und/oder chemischen Behandeln der optischen Substrate 12 angeordnet ist/sind (angedeutet in Figur 1). Eine Unterseite 66 des Substrathalters 14 weist zu der oder den Vorrichtung(en) 69. Während der Behandlung der optischen Substrate 12 durch die Vorrichtung(en) 69 wird gegebenenfalls der Substrathalter 14 durch die Substrathalterhaltevorrichtung 26 mit einer vorgegebenen Frequenz gedreht.

Nach Abschluss der Behandlung wird der Substrathalter 14 durch die Substrathalterhaltevorrichtung 26 wieder in die Schwenkebene E hinauf bewegt, das Schleusenventil 20 zur zweiten Substrataufnahmekammer 34 geöffnet und der Schwenkarm 24 aus der zweiten Substrataufnahmekammer 34 an die zweite Arbeitsposition 40 verschwenkt, was in den Figuren 1 und 5 gezeigt ist. Dort wird der Schwenkarm 24 mit dem Substrathalter 14 gekoppelt und anschließend der Substrathalter 14 von der Substrathalterhaltevorrichtung 26 in der Substratbehandlungskammer 28 entkoppelt.

Der Schwenkarm 24 bewegt nun den Substrathalter 24 in die zweite Substrataufnahmekammer 34 an die erste Arbeitsposition 38 in der zweiten Substrataufnahmekammer 34. Dort wird der Substrathalter 14 mit der Substrathalterhaltevorrichtung 26 der zweiten Substrataufnahmekammer 34 gekoppelt und anschließend der Schwenkarm 24 vom Substrathalter 14 entkoppelt und zur Seite bewegt. Das Schleusenventil 20 wird wieder geschlossen, und die Substratbehandlungskammer 34 bleibt evakuiert.

Die zweite Substrataufnahmekammer 34 dient hier als Entladekammer und weist dementsprechend in einer Seitenwand ein Schleusenventil 68 auf. Dieses Schleusenventil 68 wird nun geöffnet (nachdem die zweite Substrataufnahmekammer 34 belüftet wurde) und auf geeignete Weise der Substrathalter 14 aus der Behandlungsanlage 10 entnommen.

Aus der in Figur 5 gezeigten Darstellung wird deutlich, dass der Substratbehandlungskammer 28 eine Servicetür 71 zugeordnet ist, die geöffnet werden kann, um so Zugang zur Substratbehandlungskammer 28 zu erhalten. Die Servicetür 71 ist dabei entgegengesetzt zu den Schleusenventilen 68 der Substrataufnahmekammern 32, 34 angeordnet, wodurch die Zugänglichkeit maximiert bzw. optimiert ist.

Während die Schleusenventile 68 in diesem Beispiel die Substrataufnahmekammern 30, 32 mit einem Reinraum verbinden, sodass das Be- und Entladen des Substrathalters 14 direkt aus dem bzw. in den Reinraum erfolgt, grenzt die Servicetür 71 hier an einen sogenannten Grauraum an. An einen Grauraum werden geringere Anforderungen bezüglich der Luftreinheit gestellt als an einen Reinraum. Das vereinfacht Wartungsarbeiten an der Substratbehandlungskammer 28, insbesondere an der Vorrichtung 69.

Die Servicetür 71 ist hier in der Schwenkebene E nach außen gewölbt und bildet so einen Teil des Volumens, das zur Aufnahme des Substrathalters 14 notwendig ist. Dementsprechend ist hier die Substrathalterhaltevorrichtung 26 der Substratbehandlungskammer 28 nahe der Servicetür 71 angeordnet.

Abgesehen von der Servicetür 71 hat die Substratbehandlungskammer 28 in diesem Beispiel in einer Draufsicht (siehe z.B. Figur 6) eine dreieckige Form. Hierdurch ergibt sich eine optimierte Flächenausnutzung, der der benötigte Bauraum für die Behandlungsanlage 10 minimiert werden kann.

Wie in Figur 6 gut zu erkennen ist, ist das Schleusenventil 20 hier mit seiner Öffnung so ausgerichtet, dass ein Mittelpunkt einer Breite b der Öffnung mit einem Mittelpunkt M des Bewegungskreisbogens 50 zwischen der ersten Arbeitsposition 38 (und damit der Substrathalterhaltevorrichtung 26) in der Substrataufnahmekammer 34 und der zweiten Arbeitsposition 40 (und damit der Substrathalterhaltevorrichtung 26) in der Substratbehandlungskammer 28 zusammenfällt. Eine Tangente t am Mittelpunkt M steht dabei senkrecht auf einer durch die Breite b definierten Gerade.

Figur 4 zeigt beispielhaft, wie die beschriebene Behandlungsanlage 10 nach Belieben durch weitere Vakuumkammern 18 in Form von Substratbehandlungskammern 28 und Substrataufnahmekammern 30 erweitert werden kann. Beispielhaft ist eine abwechselnde Abfolge von Substrataufnahmekammern 30 und Substratbehandlungskammern 28 dargestellt, die in einer Reihe nebeneinander angeordnet sind. Zwischen benachbarten Vakuumkammern 18 ist jeweils ein nicht dargestelltes Schleusenventil 20 angeordnet, sodass jeder Schwenkarm 24 mit einem damit gekoppelten Substrathalter 14 zwischen zwei benachbarten Vakuumkammern 18 jeweils zwischen einer ersten Arbeitsposition 38 und einer zweiten Arbeitsposition 40 bewegt werden kann.

Um einen Substrathalter 14 in der Behandlungsanlage 10 weiterzureichen, ist hier wenigstens eine der Substrataufnahmekammern 30 so ausgelegt, dass dort zwei Schwenkwellen 36 mit jeweils einem Schwenkarm 24 angeordnet sind. Diese Substrataufnahmekammer 30 ist in Figur 4 mit dem Bezugszeichen 70 versehen. Beide Schwenkarme 24 können auf dieselbe erste Arbeitsposition 38 in dieser Substrataufnahmekammer 70 zugreifen, da diese auf den Bewegungskreisbögen 50 beider Schwenkarme 24 liegt.

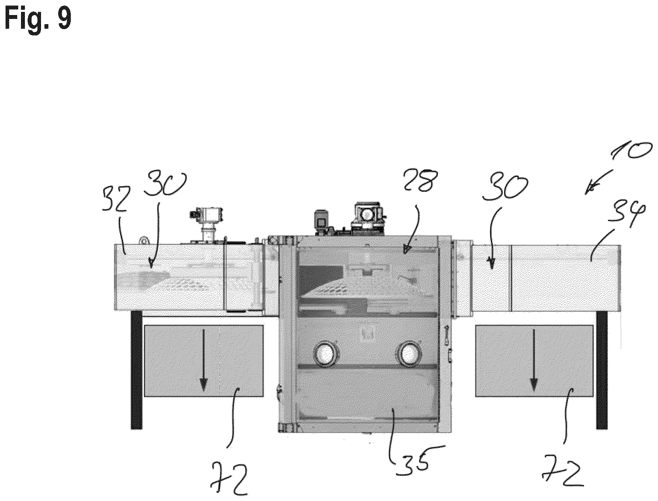

Außerdem können optional weitere Arbeitspositionen 37 z.B. in einer oder mehreren Substrataufnahmekammern 30 vorhanden sein, an denen etwa ein Substrathalter 14 für eine gewisse Zeit oder für eine in der Substrataufnahmekammer 30 durchzuführende weitere Behandlung abgelegt werden kann. Dies ist auch beispielsweise in der Figur 9 gezeigt, in der die Behandlungsanlage 10 in einer Rückansicht gezeigt ist. Die weiteren Arbeitspositionen 37 sind durch entsprechende Module 72 gewährleistet, die beispielsweise unterhalb der Substrataufnahmekammern 30 angeordnet sein können.

Nach dem gezeigten Prinzip können auch Abzweigungen und Weichen realisiert werden, wobei die Vakuumkammern 18 auch in einer flächigen Anordnung, nicht nur in einer linearen Anordnung, zueinander platziert werden können. So lässt sich die Behandlungsanlage 10 nach Belieben erweitern.

## Patentansprüche

1. Behandlungsanlage (10) für optische Substrate (12),
mit wenigstens einer Substrataufnahmekammer (30, 32, 34, 70) und wenigstens einer Substratbehandlungskammer (28), wobei die Substrataufnahmekammer (30, 32, 34, 70) und die Substratbehandlungskammer (28) als evakuierbare Vakuumkammern (18) ausgebildet sind,
mit einer Substrattransporteinrichtung (22), die dazu ausgelegt ist, einen Substrathalter (14) mit einer Vielzahl von Halterungen (16) für zu behandelnde optische Substrate (12) von der Substrataufnahmekammer (30, 32, 34, 70) in die Substratbehandlungskammer (28) zu bewegen,
wobei die Substrattransporteinrichtung (22) wenigstens einen starren Schwenkarm (24) aufweist, der an einem ersten Ende (25) an einer Schwenkwelle (36) fixiert ist und an einem zweiten Ende (42) eine Koppelvorrichtung (44) aufweist, über die der Schwenkarm (24) mit dem Substrathalter (14) koppelbar ist, wobei die Schwenkwelle (36) in der Substrataufnahmekammer (30, 32, 34, 70) angeordnet ist, und
wobei der Schwenkarm (24) in einer Schwenkebene (E) zumindest zwischen einer ersten Arbeitsposition (38) und einer zweiten Arbeitsposition (40) verschwenkbar ist, die beide auf einem Bewegungskreisbogen (50) liegen, entlang dem sich die Koppelvorrichtung (44) bewegen kann, wobei die erste Arbeitsposition (38) in der Substrataufnahmekammer (30, 32, 34, 70) und die zweite Arbeitsposition (40) in der Substratbehandlungskammer (28) liegt, und
wobei die Substrattransporteinrichtung (22) so ausgebildet ist, dass die Koppelvorrichtung (44) sowohl an der ersten Arbeitsposition (38) als auch an der zweiten Arbeitsposition (40) mit dem Substrathalter (14) koppelbar und vom Substrathalter (14) entkoppelbar ist.

2. Behandlungsanlage (10) nach Anspruch 1, wobei die Behandlungsanlage (10) mehrere Substrataufnahmekammern (30, 32, 34, 70) aufweist.

3. Behandlungsanlage (10) nach Anspruch 2, wobei die Substrattransporteinrichtung (22) dazu ausgelegt ist, den Substrathalter (14) von der Substratbehandlungskammer (28) wahlweise in eine erste Substrataufnahmekammer (32) und eine zweite Substrataufnahmekammer (34) zu bewegen.

4. Behandlungsanlage (10) nach Anspruch 2 oder 3, wobei zumindest eine der mehreren Substrataufnahmekammern (30, 32, 34, 70) ein Schleusenventil (68) zu einem nicht evakuierten Bereich aufweist und als Belade- und/oder Entladekammer für den Substrathalter (14) dient.

5. Behandlungsanlage (10) nach einem der Ansprüche 2 bis 4, wobei die Substratbehandlungskammer (28) zwischen einer ersten Substrataufnahmekammer (32) und einer weiteren Substrataufnahmekammer (30, 32, 34, 70) der mehreren Substrataufnahmekammern (30, 32, 34, 70) angeordnet ist, und in der ersten Substrataufnahmekammer (32) und in der weiteren Substrataufnahmekammer (30, 34, 70) jeweils zumindest eine Schwenkwelle (36) mit einem Schwenkarm (24) angeordnet ist, wobei die erste Substrataufnahmekammer (32) und die weitere Substrataufnahmekammer (30, 34, 70) jeweils über ein Schleusenventil (68) mit einem nicht evakuierten Bereich verbunden sind, und wobei die erste Substrataufnahmekammer (32) als Beladekammer und die weitere Substrataufnahmekammer (30, 34, 70) als Entladekammer dient oder die erste Substrataufnahmekammer (32) als Entladekammer und die weitere Substrataufnahmekammer (30, 34, 70) als Beladekammer dient.

6. Behandlungsanlage (10) nach einem der vorhergehenden Ansprüche, wobei die Substrataufnahmekammer (30, 32, 34, 70) und die Substratbehandlungskammer (28) direkt benachbart zueinander angeordnet und durch ein Schleusenventil (20) miteinander verbunden sind.

7. Behandlungsanlage (10) nach einem der vorhergehenden Ansprüche, wobei in der Substratbehandlungskammer (28) eine Vorrichtung (69) zum physikalischen und/oder chemischen Behandeln der optischen Substrate (12) angeordnet ist, insbesondere wobei der Substrathalter (14) eine Oberseite (48) und eine der Oberseite (48) entgegengesetzte Unterseite (66) aufweist, wobei die Kopplung des Schwenkarms (24) mit dem Substrathalter (14) an der Oberseite (48) des Substrathalters (14) erfolgt und die Vorrichtung (69) zum physikalischen und/oder chemischen Behandeln der optischen Substrate (12) der Unterseite (66) des Substrathalters zugewandt ist.

8. Behandlungsanlage (10) nach einem der vorhergehenden Ansprüche, wobei der Schwenkarm (24) zwischen der Schwenkwelle und der Koppelvorrichtung gekrümmt verläuft.

9. Behandlungsanlage (10) nach einem der vorhergehenden Ansprüche, wobei der Substrathalter (14) wenigstens eine Koppelungsstruktur (46) für die Koppelvorrichtung (44) aufweist und wobei die Koppelvorrichtung (44) dazu ausgelegt ist, mit der Koppelungsstruktur (46) kraft- und/oder formschlüssig zusammenzuwirken, um den Substrathalter (14) mit dem Schwenkarm (24) zu koppeln, und von der Koppelungsstruktur (44) gelöst zu werden, um den Substrathalter (14) vom Schwenkarm (24) zu entkoppeln.

10. Behandlungsanlage (10) nach einem der vorhergehenden Ansprüche, wobei der Substrathalter (14) einen zentralen Angriffspunkt für die Koppelvorrichtung (44) des Schwenkarms aufweist.

11. Behandlungsanlage (10) nach einem der vorhergehenden Ansprüche, wobei die Substrattransporteinrichtung (22) zumindest an der zweiten Arbeitsposition (40) in der Substratbehandlungskammer (28) eine Substrathalterhaltevorrichtung (26) umfasst, die dazu ausgelegt ist, mit dem Substrathalter (14) zu koppeln und den Substrathalter (14) positionsfest festzuhalten, insbesondere wobei die Substrattransporteinrichtung (22) so ausgebildet ist, dass die Substrathalterhaltevorrichtung (26) und zumindest die Koppelvorrichtung (44) des Schwenkarms (24) in einer Richtung (R) senkrecht zur Schwenkebene (E) des Schwenkarms (24) relativ zueinander beweglich sind.

12. Behandlungsanlage (10) nach einem der vorhergehenden Ansprüche, wobei alle Antriebe (52, 56) der Substrattransporteinrichtung (22) außerhalb der Vakuumkammern (18) in nicht evakuierten Bereichen der Behandlungsanlage (10) angeordnet sind.

13. Behandlungsanlage (10) nach einem der vorhergehenden Ansprüche, wobei die Substratbehandlungskammer (28) eine Servicetür (71) aufweist, die einen Zugang zu einem Inneren der Substratversorgungkammer (28) ermöglicht.

14. Verwendung eines Koppelmechanismus (47) bei einer Behandlungsanlage (10) nach einem der vorhergehenden Ansprüche, wobei der Koppelmechanismus (47) eine Koppelvorrichtung (44), eine an einem Substrathalter (14) vorgesehene Koppelungsstruktur (46) sowie eine Substrathalterhaltevorrichtung (26) umfasst, und wobei die Koppelungsstruktur (46) eingerichtet ist, sowohl mit der Koppelvorrichtung (44) als auch mit der Substrathalterhaltevorrichtung (26) zusammenzuwirken, sodass der Substrathalter (14) über die Koppelungsstruktur (46) in einem ersten Zustand mit der Substrathalterhaltevorrichtung (26) und in einem zweiten Zustand mit der Koppelvorrichtung (44) gekoppelt ist.

15. Verfahren zum Betrieb einer Behandlungsanlage (10) für optische Substrate (12), insbesondere nach einem der vorhergehenden Ansprüche, wobei die Behandlungsanlage (10) wenigstens eine Substrataufnahmekammer (30, 32, 34, 70) und wenigstens eine Substratbehandlungskammer (28) sowie eine Substrattransporteinrichtung (22) mit wenigstens einem Schwenkarm (24) umfasst, wobei die Substrattransporteinrichtung (22) dazu ausgelegt ist, einen Substrathalter (14) zwischen der Substrataufnahmekammer (30, 32, 34, 70) und der Substratbehandlungskammer (28) zu bewegen, sowie einen Koppelmechanismus (47), der eine am Schwenkarm (24) angerordnete Koppelvorrichtung (44), eine am Substrathalter (14) vorgesehene Koppelungsstruktur (46) sowie eine Substrathalterhaltevorrichtung (26) umfasst, mit den folgenden Schritten:
- Beladen des Substrathalters (14) aus einem nicht evakuierten Bereich (51) in die Substrataufnahmekammer (30) und Koppeln des Substrathalters (14) mit der Substrathalterhaltevorrichtung (26) in der Substrataufnahmekammer (30), und
- Koppeln des Substrathalters (14) mit dem Schwenkarm (24) in der Substrataufnahmekammer (30).
